Europäisches Patentamt

(19) European Patent Office

Office européen des brevets

(11) **EP 0 709 829 A2**

(12) **EUROPEAN PATENT APPLICATION**

(43) Date of publication:
01.05.1996 Bulletin 1996/18

(51) Int. Cl.$^6$: **G11B 5/39**, G01R 33/09

(21) Application number: 95116825.1

(22) Date of filing: 25.10.1995

(84) Designated Contracting States:
DE FR GB

(30) Priority: 28.10.1994 JP 265727/94

(71) Applicant: SONY CORPORATION
Tokyo 141 (JP)

(72) Inventors:
• Asada, Kazutoshi,
c/o Sony Corp.
Shinagawa-ku, Tokyo (JP)
• Saito, Norio,
c/o Sony Corp.
Shinagawa-ku, Tokyo (JP)
• Shibata, Takuji,
c/o Sony Corp.
Shinagawa-ku, Tokyo (JP)

(74) Representative: TER MEER - MÜLLER -
STEINMEISTER & PARTNER
Mauerkircherstrasse 45
D-81679 München (DE)

(54) **Magneto-resistive effect sensor**

(57) A magneto-resistive effect magnetic sensor having a magnetic layer whose resistivity is changed with a recording magnetic field derived from a magnetic recording medium. The magnetic sensor includes a magnetic layer having a magneto-resistive effect and a high-resistance magnetic layer formed on the magnetic layer via a non-magnetic layer. A resistance ratio of the high-resistance magnetic layer to the magnetic layer is set so as to be not less than 2.4.

# FIG.1

MAGNETIC RECORDING MEDIUM

EP 0 709 829 A2

## Description

### BACKGROUND OF THE INVENTION

This invention relates to a magneto-resistive effect magnetic sensor having a magnetic layer whose resistivity is changed with a recording magnetic field derived from a magnetic recording medium. More particularly, it relaters to a thin-film magnetic head for detecting changes in resistance as a playback output voltage.

In keeping up with the recent tendency towards a small size and large capacity hard disc device, there is an increasing demand for a small-sized hard disc on the order of e.g., 2.5 inches in connection with the possible application to a portable computer typified by a notebook-type personal computer.

With the small-sized hard disc, since the speed of the recording medium is lowered depending on the disc diameter, the playback output is lowered with a conventional induction magnetic head whose playback output depends upon the velocity of the recording medium, thus proving a hindrance in increasing the disc capacity.

The magneto-resistive effect magnetic head (MR head), in which changes in resistance of a magnetic layer (MR element) having the magneto-resistive effect of being changed in resistivity by a magnetic field are detected as a playback output voltage, is attracting attention as a magnetic head capable of realizing a high capacity in a small-sized hard disc since the playback output is not dependent on the velocity of the recording medium and a high playback output may be achieved for a lower speed of the recording medium.

This MR thin-film head is a playback magnetic head exploiting the so-called magneto-resistive effect in which the electrical resistance is changed with the angle defined between the direction of magnetization in a transition metal material and the direction of the current flowing therein. That is, if the MR element is subjected to the stray magnetic flux from the magnetic recording medium, the direction of magnetization of the MR element is changed by the magnetic flux and assumes an angle conforming to the magnetic quantity with respect to the direction of the current flowing in the MR element. Thus the electrical resistance of the MR element is changed and a change in voltage corresponding to this change in the electrical resistance appears across both terminal electrodes of the MR element in which flows the current. The magnetic recording signals may be read out with this change in voltage as a voltage signal.

The MR thin-film head is produced by depositing the MR element, an electrode film or an insulating layer on a slider by a thin-film forming technique and by etching the films to a preset shape by a photolithographic technique. A lower magnetic pole and an upper magnetic pole as shielding elements are arranged for defining the gap length during reproduction for prohibiting unneeded magnetic flux from entering the MR element.

Specifically, a so-called vertical type MR thin-film magnetic head, in which the sense current flows in a direction perpendicular to the track width, has a non-magnetic substrate, on which an insulating layer, a soft magnetic film as the lower magnetic pole and an insulating layer formed of $Al_2O_3$ or $SiO_2$, are deposited in this order. On this insulating layer is arranged an MR element so that its length is perpendicular to its surface facing the magnetic recording medium (the surface on which slides the magnetic recording medium) and so that its one end face is exposed on the surface on which slides the magnetic recording medium. Both ends of the MR element are provided with front and rear electrodes for supplying the current to the MR element, and the insulating layer formed of $Al_2O_3$ or $SiO_2$ is formed on the MR element. The insulating layer is sandwiched between the front and rear electrodes. On the insulating layer, a bias conductor facing the MR element, another insulating layer and a soft magnetic film as the upper magnetic pole, are layered in this order for constituting the MR thin-film head.

Since the above-described MR thin-film magnetic head is of such a structure in which the MR device is sandwiched by the upper and lower magnetic poles, it is possible to improve the S/N ratio and the recording density of the playback output as compared to that not having the upper and lower magnetic poles.

In general, magnetic sensors exploiting the MR element, that is MR sensors, to say nothing of the above-mentioned MR thin-film head, magnetic domains tend to be produced in the MR element thus producing the so-called Barkhausen noise due to movement of the magnetic wall caused by the external magnetic field.

For coping with such problem, it has been contemplated to provide a double-layer magnetic sensing section of the vertical type MR thin-film head in which the magnetic wall liable to be produced in the MR element is inhibited for avoiding generation of the Barkhausen noise. However, in such case, the two MR layers are electrically connected in parallel to each other, thus excessively lowering the electrical resistance and significantly lowering the sensitivity of the MR sensor. While it may be envisaged to use the thin film thickness of each MR element on the order of 15 nm for increasing the electrical resistance of each MR element, it has been shown that the rate of change in resistance is lowered when the thickness of each MR element becomes smaller than 30 nm. Thus a limitation is set to reduction in thickness of the MR element.

Thus it is extremely difficult to suppress the generation of the Barknausen noise in the MR sensor and to maintain high sensitivity, and a demand has been raised towards a method which possibly solves the above deficiency.

### OBJECT AND SUMMARY OF THE INVENTION

It is therefore an object of the present invention to provide a magneto-resistive effect magnetic sensor having a magnetic layer (MR element) exhibiting a magneto-resistive effect of being changed in resistivity with a magnetic field and which is configured for detecting the change in resistance of the MR element as a playback output voltage.

The present invention is directed to a magneto-resistive effect magnetic sensor having a magnetic layer whose resistivity is changed with a recording magnetic field derived from a magnetic recording medium, wherein changes in resistance in the MR element are detected as a playback output voltage.

According to the present invention, there is provided a magneto-resistive effect magnetic sensor including a magnetic layer having a magneto-resistive effect and a high-resistance magnetic layer formed thereon via a non-magnetic layer, wherein a resistance ratio of the high-resistance magnetic layer to the magnetic layer is set so as to be not less than 2.4. If the resistance ratio is less than 2.4, the sense current flowing into the MR element is insufficient such that desired sensitivity cannot be achieved.

The material of the high-resistance magnetic layer is preferably a crystalline material or an amorphous material. In addition, the material preferably has magnetic properties, such as anisotropic magnetic field, saturation magnetization, coercivity or magnetostriction constants substantially equivalent to those of the MR element.

If the MR element has the saturation magnetization different from that of the high-resistance magnetic layer, there is a risk that the directions of magnetization thereof are not stabilized in the anti-parallel magnetized state, so that a magnetic wall tends to be formed.

On the other hand, if, when the MR element has the anisotropic magnetic field different from that of the high-resistance magnetic layer, the external magnetic field is strengthened along the difficult axis of the MR element and the high-resistance magnetic layer, the angles of rotation of magnetization of the MR element and the high-resistance magnetic layer with respect to the external magnetic field in the course of magnetization of the MR element and the high-resistance magnetic layer differ from each other, as a result of which discontinuities (jumps) are undesirably produced in the resistance change in the MR element. In effect, a magneto-static interaction operates on the MR element and the high-resistance magnetic layer via the non-magnetic layer in a direction of equating the rates of rotation of magnetization of the MR element and the high-resistance magnetic layer. This means that magnetization of the MR element and hence the sensitivity of the MR element are influenced by the anisotropic magnetic field. Although it is possible in principle to improve sensitivity of the MR element by suitably setting e .g., the anisotropic magnetic field of the high-resistance magnetic layer, it remains indefinite to which extent the discontinuities of resistance changes in the MR element can be suppressed by the magneto-static interaction operating on the MR element and the high-resistance magnetic layer. In addition, a magnetic wall tends to be formed by the unbalance in magnetization of the MR element and the high-resistance magnetic layer. Thus, in view of suppressing the Barkhausen noise, it is felt to be desirable that the anisotropic magnetic field of the MR element be equal to that of the high resistance magnetic layer.

The material of the non-magnetic layer is preferably an insulating material or an electrically conductive material. Specifically, an insulating material, such as $Al_2O_3$ or $SiO_2$ or an electrically conductive material, such as Ti, Ta, Mo, W or Cr, may be employed.

The MR sensor of the present invention may be typified by a magneto-resistive effect thin-film magnetic head (MR thin-film head) in which the MR element is formed by a thin-film forming technique and a change in resistance of the MR element is detected as a playback output voltage. Preferably, the magnetic head is loaded on a small-sized hard disc for realizing high storage capacity.

The MR thin-film head may be a so-called shield type MR thin-film head in which the MR element is formed between the lower and upper magnetic poles and the magnetic flux other than the signal magnetic flux is absorbed by the upper or lower magnetic pole without being intruded into the MR element. The MR thin-film head may similarly be comprised of a lower magnetic pole and an upper magnetic pole having one ends magnetically connected to each other. The lower magnetic pole or the upper magnetic pole is fractionated and a magnetic layer exhibiting magneto-resistive effect is provided at a fractionated portion for constituting a magnetic conducting path.

With the MR sensor of the present invention, a high-resistance magnetic layer is provided in an upper-layer portion or in a lower-layer portion of the MR element via the non-magnetic layer. If no external magnetic field is applied to the MR thin-film head, the states of magnetization of the MR element and the high-resistance magnetic layer are anti-parallel along the easy axis, while no magnetic wall is generated. If the external magnetic field applied to the MR thin-film head is strengthened along the difficult axis, the directions of magnetization of the MR element and the high-resistance magnetic layer are rotated from the anti-parallel state by the process of rotation of magnetization. If the external magnetic field is strengthened further, the MR element and the high-resistance magnetic layer are magnetized to the same direction. Since the difficult axes of both the MR element and the high-resistance magnetic layer are aligned with the direction of propagation of the magnetic flux, no magnetic wall is formed, thus evading generation of the Barkhausen noise.

The resistance ratio of the high-resistance magnetic layer 23 to the MR element 21 is not less than 2.4. If the resistance of the MR element is R, the variation of the resistance R due to the magneto-resistive effect of the MR element is ΔR and the resistance of the high-resistance magnetic layer is Rh, ΔRm which is the maximum resistance variation of the magnetic sensor section constituted by the high-resistance magnetic layer and the MR element via the non-magnetic layer is given by

$$\Delta Rm = 1/\{1/(R+\Delta R) + 1/Rh\} - 1/(1/R + 1/Rh)$$

$$= \{t/(1+t)\}^2 \, \Delta R \qquad (1)$$

where $t = Rh/R$. On the other hand, $\Delta R'm$ which is the maximum resistance variation of the magnetic sensor section of a conventional MR sensor in which the magnetic sensor unit is constituted by a two-layer MR element is given by

$$\Delta R'm = 1/\{1/(R+\Delta R) + 1/(R+\Delta R\} - R/2$$

$$= \Delta R/2 \qquad (2)$$

In order for $\Delta Rm$ to be larger than $\Delta R'm$, it suffices if

$$Rh/R > 2.4 \qquad (3)$$

as may be seen from (1) and (2). If, for example, the resistance ratio $Rh/R$ is 5,

$$\Delta Rm/\Delta R'm = 1.38 \qquad (4)$$

meaning that the output is improved by about 40%.

Thus, with the present invention, the Barkhausen noise may be suppressed, while high sensitivity may be maintained.

BRIEF DESCRIPTION OF THE DRAWINGS

Fig.1 is a schematic plan view showing a MR thin-film magnetic head according to the present invention, with an upper magnetic pole being removed.

Fig.2 is a cross-sectional view taken along line A-A' of Fig.1 for schematically illustrating essential portions of the MR thin-film magnetic head shown in Fig. 1.

Fig.3 is a schematic perspective view showing the construction of the magnetic sensing portion.

Fig.4 schematically shows the direction of magnetization in case an external magnetic field is not applied to the MR thin-film head.

Fig.5 schematically shows changes in the direction of magnetization in case the external magnetic field starts to be applied to the MR thin-film head.

Fig.6 schematically shows the direction of magnetization in case a stronger external magnetic field is applied to the MR thin-film head.

Fig.7 is a cross-sectional view showing essential portions of a modification of an MR thin-film magnetic head according to the present invention.

DESCRIPTION OF THE PREFERRED EMBODIMENTS

Referring to the drawings, an embodiment of the present invention, in which the MR sensor is applied to a magneto-resistive effect thin-film magnetic head (MR thin-film head) is applied, is explained in detail.

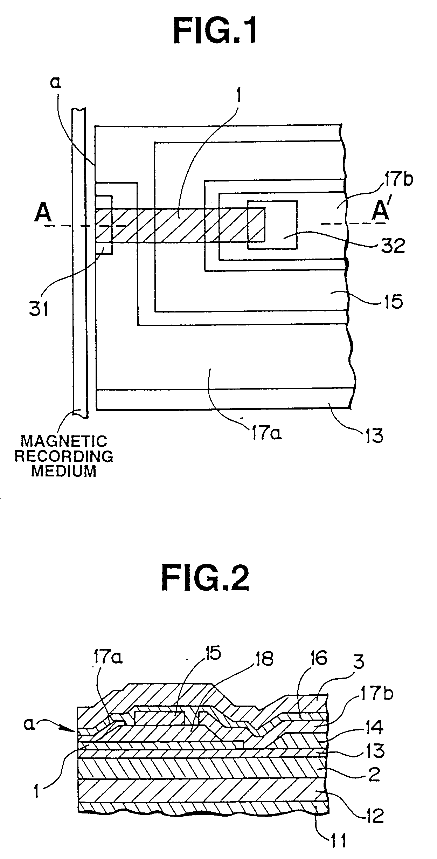

Specifically, the MR thin-film head has a magnetic sensor section 1 sandwiched between a lower magnetic pole 2 and an upper magnetic pole 3 and extending perpendicular to the surface on which slides the magnetic recording medium, and hence is constituted as a vertical type thin-film magnetic head, as shown in Figs.1 and 2.

Specifically, a lower magnetic pole 2, which is a shield magnetic film formed of e.g., Ni-Fe, is deposited on a non-magnetic substrate 11 formed of $Al_2O_3$-TiC via an insulating layer 12, and an insulating layer 13 of silicon nitride ($SiO_2$) is deposited on the surface of the lower magnetic pole 2.

The magnetic sensing section 1 is formed on the insulating layer 13 and an insulating layer 14 formed of $SiO_2$ is deposited at a pre-set portion in the vicinity of the magnetic sensing section 1. On the magnetic sensing section 1 is deposited a bias conductor 15 via an insulating layer 18 for impressing a bias magnetic field on an MR element 21 constituting the magnetic sensing section 1 as later explained. On the bias conductor 15 is formed an insulating layer 16 of $SiO_2$ on which the upper magnetic pole 3 formed by a magnetic pole of Ni-Fe is deposited for completing the MR thin-film head.

The arraying position and the pattern of the bias conductor 15 may be set in any desired manner. For example, a two-layered structure or a helical structure may be employed. A permanent magnet thin film may also be employed instead of the structure across which a magnetic field is induced by the electric current.

The insulating films 3, 14 may also be formed of beryllium oxide or aluminum nitride in place of $SiO_2$.

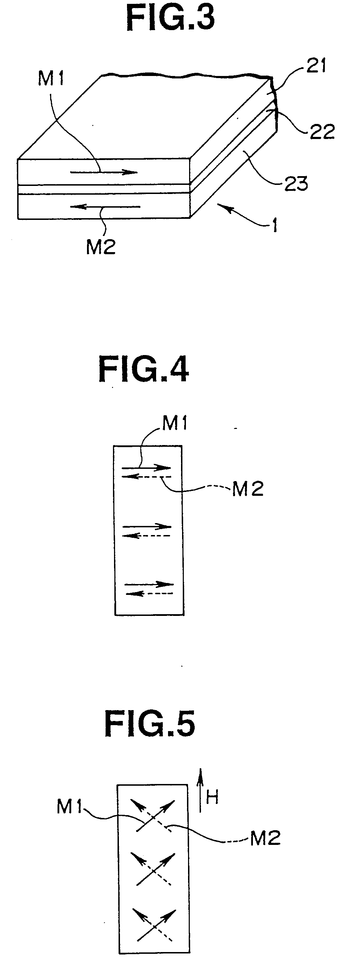

The magnetic sensor 1 is made up of a magnetic layer exhibiting magneto-resistive effect (MR element) 21, a non-magnetic layer 22 and a high resistance magnetic layer 23 provided in an upper-layer portion or a lower-layer portion of the MR element 21, with the non-magnetic layer 22 in-between, as shown in Fig. 3. The resistance ratio of the high resistance magnetic layer 23 to the MR element 21 is set so as to be 2.4 or higher, herein 5 to 10. If the resistance ratio is less than 2.4, the amount of the sense current flowing into the MR element 21 becomes insufficient so that desired sensitivity can not be achieved. Since the MR element has a resistivity of 20 to 30 ohm/cm, it is sufficient if the material of the high-resistance magnetic layer 23 is selected taking into account such resistivity of the MR element.

The MR element 21 is formed of Ni-Fe and has a thickness of 39 nm. In addition to Ni-Fe, the metals Fe, Ni or Fe exhibiting uniaxial anisotropy or not exhibiting anisotropy in the major plane and also displaying magneto-resistive effect and stable magnetic properties, or alloys thereof, may be employed as the material for the MR element 21.

The non-magnetic layer 22 is formed to a thickness of 100 Å from $Al_2O_3$ as an insulating material. In addition to $Al_2O_3$, an insulating material, such as $SiO_2$, or an electrically conductive material, such as Ti, Ta, Mo, W or Cr may be used as materials of the non-magnetic material 22.

The high-resistance material 23 is formed to a thickness of 30 nm from a so-based amorphous material, specifically CoZrNb or CoZrHf. In addition to the Co-based amorphous materials, crystalline materials may also be employed for the high-resistance magnetic layer 23. These materials need to have magnetic properties, such as anisotropic magnetic field Hk, saturation magnetization Ms, coercivity Hc or magnetostriction constant $\lambda$ equivalent those of the MR element 21 and a resistance ratio with respect to the MR element 21 of the high-resistance magnetic layer 23 of not less than 2.4.

With the above-described MR thin-film head, the magnetic sensor section 1 is arranged so that its longitudinal direction is perpendicular to the surface thereof facing the magnetic recording medium, that is the surface on which slides the magnetic recording medium, and so that its one end face is exposed to the surface on which slides the magnetic recording medium. A pair of electrodes formed by electrically conductive films, namely a font end electrode 17a and a rear end electrode 17b, are formed at an end of the magnetic sensor section 1 towards the surface on which slides the magnetic recording medium and at a portion spaced apart a preset distance from the end of the sensor 1, respectively. The front end electrode 17a and the rear end electrode 17b are formed for flowing the sense current along the length of the sensor 1, that is in a direction along the length of the sensor 1. That is, the magnetic sensor 1 and the insulating layer 18 are sandwiched between the front end electrode 17a and the rear end electrode 17b. With the MR thin-film head, the region of the magnetic sensor section 1 between the front end electrode 17a and the rear end electrode 17b exhibits the magneto-resistive effect.

For fabricating the MR thin-film head, after a pre-set resist pattern is formed via the insulating layer 12 on the non-magnetic substrate 11 formed e.g., of $Al_2O_3$-TiC, the lower magnetic pole 2 is formed by a magnetic film of e.g., Ni-Fe by e.g., an ion beam etching method.

The insulating layer 13 is then formed on the lower magnetic pole 2, and the magnetic sensor 1 is formed on the insulating layer 13. That is, the high-resistance magnetic layer 23, non-magnetic layer 22 and the MR element 21 of the Co-based amorphous material, $Al_2O_3$ and Ni-Fe, respectively, are formed in this order on the insulating layer 13 by thin-film forming technique, that is sputtering or vacuum deposition. Then, using a photoresist, the resulting assembly is patterned to the shape of the magnetic sensor section 1 and etched to a required shape. At this time, magnetic properties, such as anisotropic magnetic field Hk, saturation magnetization Ms, coercivity Hc or magnetostriction coefficient $\lambda$ of the magnetic sensor section 1 are adapted so as to be equivalent to those of the high-resistance magnetic layer 23.

The insulating layer 14 is then formed at a pre-set portion close to the magnetic sensor section 1 and electrode holes 31, 32 are formed for forming the electrode films (the front end electrode 17a and the rear end electrode 17b). That is, a resist is first applied to form a resist layer which then is shaped to a pre-set pattern using a mask. The insulating layer 14 is etched by RIE to form the electrode holes 31, 32 to pre-set patterns. The resist layer then is removed.

The bias conductor 15 and the front end electrode 17a and the rear end electrode 17b of W, Ti or Mo are formed on the magnetic sensor section 1 via the insulating layer 18 by sputtering followed by RIE. Subsequently, the insulating layer 16 is formed.

After a Ti/Ni-Fe film is formed by sputtering on the insulating layer 16 as an under laying film for plating, a pre-set resist frame is formed. After Ni-Fe plating, the resist film is removed. A resist is further formed to a pre-set shape and removed by wet etching for forming the upper magnetic pole 3. The MR thin-film head is completed by the above procedure.

An external magnetic field was applied along the difficult axis of the MR thin film head as the sense current of 15 mA was caused to flow through the head in order to check resistance changes in the MR element 21. It was found that the MR thin-film head exhibited maximum changes in resistance 1.7 times as large as those of a conventional MR thin-film head the magnetic sensor of which is constituted by two-layer MR elements. On the other hand, the sensitivity of the MR element 21, which is the ratio of changes in resistance to changes in the magnetic field, was determined by the maximum resistance change and width of the MR characteristic curve. Since the width of the MR characteristic curve was the same for both MR thin-film heads, the present MR thin-film head is expected to have the sensitivity about 1.7 times that of the conventional MR thin-film head constituted by the two-layer MR element.

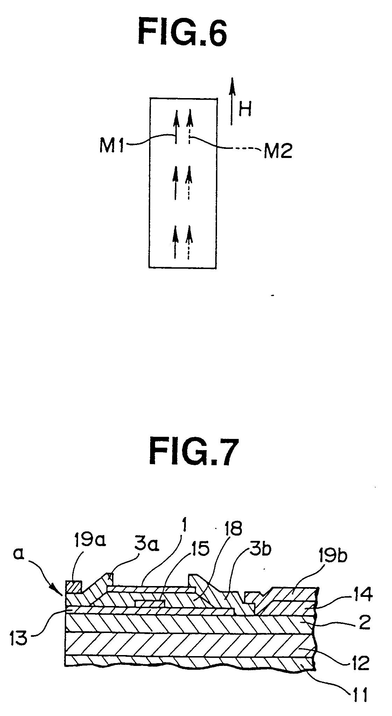

Thus, with the present embodiment, the high-resistance magnetic layer 23 is provided in the upper-layer portion or in the lower-layer portion of the MR element 21 with the interposition of the non-magnetic layer 22. If no external magnetic field is applied to the MR thin-film magnetic head, the magnetized state of the MR element 21 and the high-resistance magnetic layer 23 is anti-parallel to each other along the easy axis, without formation of magnetic wall, as shown in Figs.3 and 4, in which the direction of magnetization of the MR element 21 and that of the high-resistance magnetic layer 23 are indicated by arrows M1 and M2, respectively. If the external magnetic field H applied to the MR thin-film head is strengthened along the difficult axis, the directions of magnetization of the MR element 21 and the high-resistance magnetic layer 23 are rotated from the anti-parallel state by the process of rotation of magnetization, as shown in Fig.5. If the external magnetic field is strengthened further, the MR element 21 and the high-resistance magnetic layer 23 are magnetized to the same direction, as shown in Fig. 6. Since the difficult axes of both the MR element 21 and the high-resistance magnetic layer 23 are aligned with the direction of propagation of the magnetic flux, no magnetic wall is formed, thus evading generation of the Barkhausen noise.

The resistance ratio of the high-resistance magnetic layer 23 to the MR element 21 is not less than 2.4, so that, as compared to the conventional MR thin-film head the magnetic sensor of which is constituted by two-layer MR elements, the present MR thin-film head gives a larger output, such that, if the resistance ratio is 5, the output is improved by about 40%.

Thus, with the MR thin-film head of the illustrated embodiment, the Barkhausen noise is suppressed, while the high sensitivity is maintained.

A modification of the present invention is now explained. The MR thin-film head of the illustrated embodiment is substantially the same as that of the above embodiment except that the foremost pat of the magnetic sensor 1 is not facing the surface on which slides the magnetic recording medium. In the present modification, the parts or components similar to those of the previous embodiment are depicted by the same numerals and the corresponding description is omitted, for simplicity.

The MR thin-film head of the present modification has a lower magnetic pole 2 and an upper magnetic pole 3, as shown in Fig. 7. The lower magnetic pole 2 has its rear end 2a connected magnetically, while the upper magnetic pole 3 is fractionated at 3c into a forward magnetic pole portion 3a and a rear magnetic pole potion 3b. The fractionated portion 1 operates as an opened magnetic portion constituting a magnetic path. The MR thin-film head is not provided with electrodes, that is the front end electrode 17a or the rear end electrode 17b, while it is provided with terminal connection conductors 19a, 19b not electrically connected with terminal portions of the forward or rear magnetic poles 3a, 3b. The bias conductor 15 is provided above the magnetic sensor 1, in stead of below the sensor, as in the previous embodiment.

In the present modification, similarly to the previous embodiment, the high-resistance magnetic layer 23 is provided in an upper-layer portion or in a lower-layer portion of the MR element 21 via the non-magnetic layer 22. If no external magnetic field is applied to the MR thin-film head, the states of magnetization of the MR element 21 and the high-resistance magnetic layer 23 are anti-parallel along the easy axis, while no magnetic wall is generated. If the external magnetic field H applied to the MR thin-film head is strengthened along the difficult axis, the directions of magnetization of the MR element 21 and the high-resistance magnetic layer 23 are rotated from the anti-parallel state by the process of rotation of magnetization, as shown in Fig.5. If the external magnetic field is strengthened further, the MR element 21 and the high-resistance magnetic layer 23 are magnetized to the same direction, as shown in Fig. 6. Since the difficult axes of both the MR element 21 and the high-resistance magnetic layer 23 are aligned with the direction of propagation of the magnetic flux, no magnetic wall is formed, thus evading generation of the Barkhausen noise.

The resistance ratio of the high-resistance magnetic layer 23 to the MR element 21 is not less than 2.4, so that, as compared to the conventional MR thin-film head the magnetic sensor section of which is constituted by two-layer MR elements, the present MR thin-film head gives a larger output, such ,that, if the resistance ratio is 5, the output is improved by about 40%.

Thus, with the MR thin-film head of the illustrated embodiment, the Barkhausen noise is suppressed, while the high sensitivity is maintained.

The present invention is not limited to the above-described embodiments. For example, although the MR thin-film head has the upper magnetic pole 3 and the lower magnetic pole 2 above and below the magnetic sensor 1, respectively, the present invention may also be applied to a non-shield MR thin-film head not having the upper magnetic pole 3 or the lower magnetic pole 2 above and below the magnetic sensor 1, respectively. The present invention may also be applied to a non-shield MR thin-film head not having the upper magnetic pole 3 or the lower magnetic pole 2.

The MR sensor of the present invention may be used as various devices utilizing MR characteristics in addition to the MR thin-film head.

## Claims

1. A magneto-resistive effect magnetic sensor comprising a magnetic layer having a magneto-resistive effect and a high-resistance magnetic layer formed thereon via a non-magnetic layer, wherein the improvement resides in that
a resistance ratio of the high-resistance magnetic layer to the magnetic layer is not less than 2.4.

2. The magneto-resistive effect magnetic sensor as claimed in claim 1 wherein the high-resistance magnetic layer is formed of a crystalline material.

3. The magneto-resistive effect magnetic sensor as claimed in claim 1 wherein the high-resistance magnetic layer is formed of a non-crystalline material.

4. The magneto-resistive effect magnetic sensor as claimed in claim 1 wherein the non-magnetic layer is formed of an insulating material.

5. The magneto-resistive effect magnetic sensor as claimed in claim 1 wherein the non-magnetic layer is formed of an electrically conductive material.

6. The magneto-resistive effect magnetic sensor as claimed in claim 1 wherein the magnetic layer having the magneto-resistive effect and the high-resistance magnetic layer exhibit substantially the same saturation magnetization.

7. The magneto-resistive effect magnetic sensor as claimed in claim 1 wherein the sensor is a thin-film magnetic head formed by a thin-film forming technique.

8. The magneto-resistive effect magnetic sensor as claimed in claim 7 wherein the magnetic layer exhibiting the magneto-resistive effect is formed between a lower magnetic pole and an upper magnetic pole.

9. The magneto-resistive effect magnetic sensor as claimed in claim 7 further comprising a lower magnetic pole and an upper magnetic pole having one ends magnetically connected to each other, said lower magnetic pole or the upper magnetic pole is fractionated and a magnetic layer exhibiting magneto-resistive effect is provided at a fractionated portion to constitute a magnetic conducting path.

10. The magneto-resistive effect magnetic sensor as claimed in claim 3 wherein the non-crystalline material is a Co-based amorphous material.

11. The magneto-resistive effect magnetic sensor as claimed in claim 4 wherein the non-magnetic lye id formed of $Al_2O_3$.

# FIG.1

MAGNETIC
RECORDING
MEDIUM

# FIG.2

# FIG.3

# FIG.4

# FIG.5

# FIG.6

# FIG.7